# EUROPÄISCHE PATENTSCHRIFT

(11) **EP 1 731 007 B1**
(45) Veröffentlichungstag und Bekanntmachung des Hinweises auf die Patenterteilung: **09.06.2010**
(21) Anmeldenummer: 05715333.0
(22) Anmeldetag: 15.02.2005
(51) Int. Cl.: H05K 3/46, H05K 3/12

(54) **MULTILAYER-LEITERPLATTE SOWIE VERFAHREN ZUM HERSTELLEN EINER SOLCHEN**
MULTILAYER PRINTED CIRCUIT BOARD AND METHOD FOR THE PRODUCTION THEREOF
CARTE DE CIRCUIT IMPRIME MULTICOUCHE ET SON PROCEDE DE PRODUCTION

(30) Priorität: 30.03.2004 DE 102004016205
(43) Veröffentlichungstag der Anmeldung: 13.12.2006
(73) Patentinhaber: SEFAR AG, 9425 Thal (CH)
(72) Erfinder: WAGNER, Paul-Heinz, 64625 Bensheim (DE); HARTL, Thomas, CH-9422 Staad (CH)
(74) Vertreter: Behrmann, Niels
(86) Internationale Anmeldenummer: PCT/EP2005/001493
(87) Internationale Veröffentlichungsnummer: WO 2005/107349

(56) Entgegenhaltungen:
- US-A- 4 839 775
- US-A- 5 314 788
- US-A- 5 316 894
- PATENT ABSTRACTS OF JAPAN Bd. 015, Nr. 390 (E-1118), 3. Oktober 1991 (1991-10-03) & JP 03 157990 A (NEC CORP), 5. Juli 1991 (1991-07-05)
- PATENT ABSTRACTS OF JAPAN Bd. 014, Nr. 411 (E-0973), 5. September 1990 (1990-09-05) & JP 02 156596 A (MATSUSHITA ELECTRIC IND CO LTD), 15. Juni 1990 (1990-06-15)
- PATENT ABSTRACTS OF JAPAN Bd. 016, Nr. 570 (E-1297), 10. Dezember 1992 (1992-12-10) & JP 04 221886 A (NIPPON CHEMICON CORP), 12. August 1992 (1992-08-12)

## Beschreibung

Die vorliegende Erfindung betrifft ein Verfahren zum Herstellen einer mit Elektronikbauelementen bestückbaren Multilayer-Leiterplatte sowie eine derartige, nach einem solchen Verfahren hergestellte Leiterplatte.

Seit Jahrzehnten werden zur Realisierung von Elektronikschaltungen aller Art Leiterplatten eingesetzt, wobei diese aus einem Trägermaterial (Substrat) bestehen, welches, ein-oder mehrlagig, eine Bemusterung in Form eines metallischen Leiterbahnverlaufes trägt, auf welchem wiederum, typischerweise durch ein Lötverfahren, dann geeignete elektronische Bauelemente kontaktiert werden. Dabei ist es etablierte Herstellungspraxis, diese Bemusterung mittels einer insbesondere photolithographisch aufgebrachten Ätzmaske dergestalt zu realisieren, dass eine durchgängige, plane Metallschicht (typischerweise Kupfer) auf dem Substrat im Bereich des vorgesehenen Leiterbahnverlaufs mit einer Ätzstopmaskierung versehen wird, nach dem Aufbringen und ggf. Fixieren dieser Maskierung dann die verbleibenden (d. h. freiliegenden) Bereiche der Metallbeschichtung mittels eines Ätzverfahrens entfernt werden und somit nach dem Abtragen der Ätzstopschicht die Bemusterung zur weiteren Bestückung und zum Verlöten verbleibt.

Derartige Verfahren werden für Leiterplatten bzw. beschichtete Substrate praktisch aller Größenordnungen eingesetzt, von großformatigen Leiterplatten der Rundfunk- und Leistungselektronik mit weitgehend diskreten, oftmals manuell bestückten Bauelementen bis zu SMD-Leiterplatten und Anordnungen der Hochfrequenz- und/oder Mikroelektronik, wo Substrate bestimmter Dielektrizitätswerte eingesetzt werden und/oder Leiterbahnlängen und -dicken aus Frequenzgründen bereits kritische Abmessungen aufweisen.

Die US 5,314,788 offenbart ein Verfahren zum Herstellen einer mit Elektronikbauelementen bestückbaren Multilayer-Leiterplatte, bei welcher mittels Siebdruck eine einem Leiterbahnverlauf entsprechende elektrisch leitende Bemusterung auf ein Trägersubstrat aufgetragen wird und die durch den Leiterbahnverlauf bestimmten nicht-leitenden Zwischenräume in der Bemusterung durch Auftragen eines Füllmaterials aufgefüllt werden. Auf das Füllmaterial wird dann eine weitere Isolationsschicht aufgetragen, welche dann auf ihrer Oberfläche durch Sputtern mit einer weiteren Leiterbahnstruktur versehen ist.

Die Druckschriften JP 03 157 990 A, JP 02 156 596 A sowie US-A-5 316 894 offenbaren weitere Verfahren zum Herstellen einer mit Elektronikbauelementen bestückbaren Multilayer-Leiterplatte, wobei auch hier einzelne Verfahrensschritte mittels Siebdruckverfahren durchgeführt werden.

Allerdings sind derartige Herstellungsverfahren, bedingt durch die verschiedenen Schritte und die dafür erforderlichen, jeweils spezialisiert vorgesehenen Vorrichtungen, aufwendig, und zwar sowohl im Hinblick auf die notwendigen Investitionen, als auch die Bearbeitungszeit. Hinzu kommt, dass Ätzverfahren umweltbelastend sind und dadurch zunehmend in der öffentlichen Kritik stehen.

Aufgabe der vorliegenden Erfindung ist es daher, ein Verfahren zum Herstellen elektronischer Leiterplatten zu schaffen, welches die genannten Nachteile überwindet, insbesondere im Hinblick auf Zeitaufwand für die Produktion und Investition in Herstellungsanlagen vereinfacht bzw. verbilligt ist und zusätzlich das Entstehen schädlicher Umweltbelastung, wie etwa durch Säurebäder od. dgl., vermeidet.

Die Aufgabe wird durch das Verfahren mit den Merkmalen des Hauptanspruchs gelöst; vorteilhafte Weiterbildungen der Erfindung sind in den Unteransprüchen beschrieben.

In erfindungsgemäß vorteilhafter Weise wird die Bemusterung nicht durch Herausätzen aus des Leiterbahnverlaufs aus einer vollflächigen, elektrisch leitenden Beschichtung erzeugt, sondern durch (bezogen auf die Fläche lokal begrenztes) Aufdrucken der Bemusterung entsprechend dem tatsächlichen Leiterbahnverlauf unmittelbar auf das Trägersubstrat.

Zusätzlich wird gemäß der Erfindung eine vertiefungsfreie, plane Oberfläche dadurch erzeugt, dass neben der Bemusterung in die durch den Leiterbahnauftrag erzeugten Zwischenräume ein elektrisch nicht leitendes Füllmaterial gebracht wird, und zwar in derselben Schichtdicke wie die Dicke der elektrisch leitenden Bemusterung. Insoweit steht damit dann für weitere Schichtaufträge eine homogene, weitgehend ebene Oberfläche zur Verfügung.

Es erfolgt dann die Beschichtung dieser homogenen Oberfläche durch die erfindungsgemäß vorgesehene Lötstopmaske, so dass damit in einfacher Weise und durch lediglich drei Prozessschritte, welche zudem sämtlichst als Siebdruckvorgänge realisiert sind, eine einlagige Leiterplatte hergestellt werden kann.

Dabei ist es im Rahmen der Erfindung von Bedeutung, dass das Füllmaterial, welches im aufgebrachten Zustand der Bemusterung benachbart, für eine Homogenisierung der Leiterbahnstruktur sorgt, aus einem Material gewählt ist, welches seinerseits eine günstige Haftung auf dem unterliegenden Trägersubstrat ermöglicht, andererseits jedoch zusätzlich auch eine gute Verbindung mit dem Maskierungsmaterial herstellt.

Gemäß, einer bevorzugten Ausführungsform der Erfindung wird dies dadurch gelöst, dass für das Füllmaterial und das Maskierungsmaterial derselbe Werkstoff verwendet wird, so dass insoweit das Herstellungsverfahren weiter vereinfacht werden kann.

Auch liegt es im Rahmen einer bevorzugten Weiterbildung der Erfindung, zur Realisierung der elektrisch leitenden Bemusterung eine Kupferleitpaste oder ein (weiter bevorzugt thermisch härtbares) Gemisch zu verwenden, welches Metall sowie ein Harz und/oder einen Kunststoff enthält. Auf diese Weise lassen sich dann nicht nur, durch geeignete Gestaltung von Schichtdicke und Leiterbahnbreite, die Leitwerte der entstehenden Leitungsstruktur optimieren, auch kann insbesondere auf beliebige andere vorgegebene Schaltungsparameter einfach reagiert werden.

Die weiterbildungsgemäß vorgesehene thermische Härtbarkeit, bevorzugt sämtlicher aufzudruckender Materialien, sorgt zudem dafür, dass durch einfache Infrarotbestrahlung od. dgl. Wärmebehandlung die entstehende Struktur schnell und zuverlässig dauerhaft ausgehärtet und damit fixiert werden kann.

Während prinzipiell jede dünne leitende Bemusterung von der vorliegenden Erfindung umfasst ist, hat es sich jedoch in der Praxis als besonders geeignet herausgestellt, eine Schichtdicke zwischen ca. 18 und ca. 70 µm für die Bemusterung zu realisieren, wobei weiterbildungsgemäß hierfür dann Leitfähigkeiten im Bereich zwischen 3 und 7 mOhm x cm günstig sind.

Damit eignet sich die im Rahmen der vorliegenden Erfindung einfach erzeugte plane Oberfläche dafür, ggf. unter Zwischenschaltung geeigneter Isolationsschichten, sogenannte Multilayer-Strukturen aufzubauen, d. h. Anordnungen aus einer Mehrzahl übereinander angeordneter und typischerweise selektiv miteinander kontaktierter Leiterbahn-Bemusterungen. Gerade die Multilayer-Technologie stellt nämlich in der herkömmlichen Platinenproduktion besondere Anforderungen an die Produktion, und das vorliegende erfindungsgemäße Verfahren überwindet diese prinzipbedingten Schwierigkeiten mit besonderer Einfachheit und Eleganz.

Ein besonderer Vorteil der vorliegenden Erfindung liegt zudem darin, dass gekrümmte oder auf andere Weise nicht-plane Substratoberflächen in einfacher und zuverlässiger Weise mit einer Leiterbahnstruktur versehen werden können. Auch dies bereitet bei traditionellen Belichtungs- und Ätzprozessen typischerweise große Schwierigkeiten, während, durch entsprechendes Vorsehen einer geeigneten Siebdruckanordnung, prinzipiell beliebige siebdruckfähige Oberflächenformen der vorliegenden Erfindung zur Ausbildung von elektrisch leitenden Bemusterungen zugänglich sind.

Schließlich liegt es im Rahmen der vorliegenden Erfindung, die im Rahmen der obenliegenden Lötstopmaske freiliegenden, zu kontaktierenden Leiterbahnabschnitte durch Versilbern oder Vergolden geeignet zu vergüten. Insbesondere für Hochfrequenzanwendungen oder andere leitwert- bzw. kontaktkritische Anwendungen dürfte diese zusätzliche Maßnahme sinnvoll sein, und auch generell liegt es im Rahmen der erfindungsgemäßen Weiterbildungen, durch galvanische od. dgl. Maßnahmen (etwa auch mit Kupfer oder Zinn) die elektrische Kontakt- bzw. Oberflächengüte zu verbessern.

Während das Verfahrenserzeugnis der vorliegenden Erfindung, nämlich die nach der Erfindung produzierte Leiterplatte, prinzipiell für beliebige elektronische Schaltungsanwendungen geeignet ist, bietet es sich im Rahmen der Erfindung besonders an, derartige Produkte für die SMD-Bestückung auszubilden. Es zeigt sich nämlich, dass gemäß der Erfindung hergestellte Leiterplatten in besonders einfacher Weise in automatische Fertigungsanlagen für das Herstellen bestückter und verlöteter Leiterplatten integrierbar sein sollten, so dass insoweit eine automatisierte Vorrichtung zur Realisierung der vorliegenden Erfindung einer ansonsten bekannten SMD-Bestückungsanlage unmittelbar vorgeschaltet sein könnte.

Weitere Vorteile, Merkmale und Einzelheiten der Erfindung ergeben sich aus der nachfolgenden Beschreibung bevorzugter Ausführungsformen sowie anhand der einzigen Figur; diese zeigt in

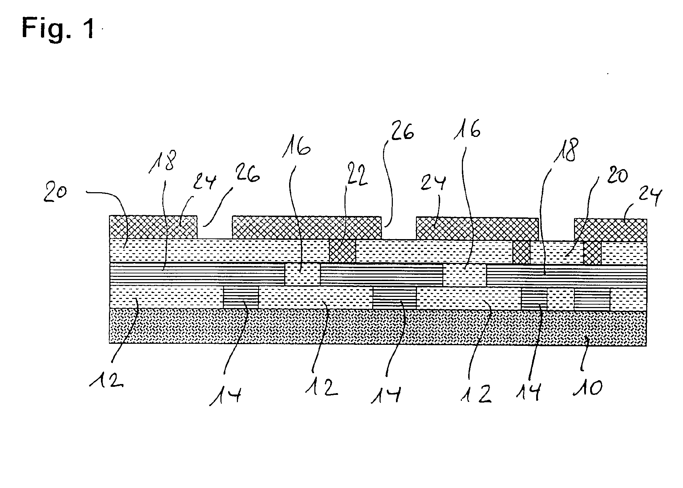

Fig. 1 eine seitliche schematische Schnittansicht des durch das erfindungsgemäße Verfahren hergestellten Verfahrensprodukts gemäß einer ersten bevorzugten Ausführungsform als mehrlagige Leiterplatte.

In der Fig. 1 beschreibt das Bezugszeichen 10 ein ansonsten bekanntes Substrat-Basismaterial; typische, bekannte Werkstoffe, die hier geeignet eingesetzt werden können, sind beispielsweise FR 1, FR 2, FR 3, FR 4, CEM 1, CEM 3, Polyimid, Polysulfon, Polyethersulfon oder Polypropylen.

Mittels Siebdruck auf dieses Basismaterial-Substrat 10 aufgebracht ist eine Bemusterung 12, welche, in der gezeigten Querschnittsansicht durch die Unterbrechungen angedeutet, eine Leiterbahnstruktur ausbildet und durch Siebdrucken einer lötfähigen Leitpaste mit einer Dicke zwischen 18 und 70 µm realisiert ist. Im konkreten Fall wurde die Kupferleitpaste ASAHI ACP-051 als Material für die Bemusterung 12 auf ein FR 4-Basismaterial 10 gedruckt.

Als nächsten Schritt wurden dann die Zwischenräume zwischen den Leiterbahnen der Bemusterung 12 durch Siebdrucken mit einem Lötstoplack TAMURA USR 2G, bezeichnet durch das Bezugszeichen 14, aufgefüllt, wobei ebenfalls eine (der Bemusterung 12 entsprechende) Schichtdicke im Bereich zwischen 18 und 70 µm gewählt wurde, so dass oberhalb der ersten, durch zweifache aufeinanderfolgende Siebdruckschritte entstandenen Beschichtungslage 12, 14 eine plane Oberfläche entsteht.

Diese Schritte werden für eine darauffolgende Lage wiederholt, und zwar wird wiederum eine Bemusterung 16 aus der vorgenannten lötfähigen Leitpaste auf die ebene Oberfläche aufgetragen, und die darin gebildeten Zwischenräume durch den Lötstoplack als Füllmaterial 18 aufgefüllt. Wiederum erhält diese Lage durch diese Maßnahme eine plane, weitgehend ebene obere Oberfläche.

In einem weiteren Siebdruckschritt wird eine dritte Leiterbahnschicht (Bemusterung) 20 aufgebracht. Die verwendete Schichtdicke entspricht den vorgenannten Schichtdicken. Auch hier erfolgt ein Auffüllen der Zwischenräume durch ein isolierendes Füllmaterial (etwa Lötstoplack oder Isolationslack), bezeichnet durch das Bezugszeichen 22.

Eine Deckschicht aus Lötstoplack als Lötstopmaske 24 bildet die oberste Schicht der in Fig. 1 gezeigten Anordnung. Diese weist eine Dicke im Bereich zwischen ca. 14 und 20 µm auf und bildet an den unmaskierten Stellen (Öffnungsflächen) Kontaktbereiche 26 für die oberste Leiterbahnschicht 20 zum unmittelbaren Auflöten von Elektronikbauelementen, zum weiteren Vergüten der Oberflächen- bzw. Kontaktqualität durch Versilbern oder Vergolden oder für andere Kontaktaufgaben aus.

Auf die so gebildete Struktur (je nach verwendetem Prozessverlauf erfolgt eine Aushärtung der einzelnen Schichten schichtweise oder gesamthaft) sind dann beliebige Typen von Elektronikbauelementen durch gängige manuelle oder automatisierte Lötverfahren oder auf anderem Wege aufbringbar, wobei die vorliegende Erfindung sich insbesondere für SMD-Technologien als besonders vorteilhaft herausgestellt hat.

Gleichwohl eignet sich die vorliegende Technologie nicht nur für Leiterplatten im klassischen Sinne, insbesondere ergeben sich als übliche Anwendungsgebiete auch der wachsende Markt der Sicherheitslabel auf Kleidungsstücken, der Kontroll- und Identifizierungslabel für Logistik od. dgl. Anwendungen, die Realisierung von Telekommunikationsschaltungen (insbesondere auch Transponderschaltungen) auf planen oder gewölbten Oberflächen, ferner das großseriengeeignete Herstellen von aktiven Antennen, etwa für GPS-Syteme, oder aber das Ausbilden von LAN-Netzwerkschaltungen und - antennen auf Flächen wie etwa dem Gehäuseinneren von Drukkern, Scannern usw..

## Patentansprüche

1. Verfahren zum Herstellen einer mit Elektronikbauelementen bestückbaren Multilayer-Leiterplatte, mit den Schritten:
- Auftragen einer einem Leiterbahnverlauf (12,16,20) entsprechenden, elektrisch leitenden Bemusterung einer Schichtdicke < 100 Mikrometern aus einer metallhaltigen, lötfähigen Paste auf ein nicht leitendes Trägersubstrat (10) mittels eines Siebdruckverfahrens,
- Auffüllen der durch den Leiterbahnverlauf bestimmten nicht leitenden Zwischenräume in der Bemusterung durch Auftragen eines Füllmaterials (14,18,22) mit der Schichtdicke mittels eines Siebdruckverfahrens,
- selektives Auftragen eines isolierenden und/oder Lötfluss stoppenden Maskierungsmaterials (24) mittels eines Siebdruckverfahrens auf die mit dem Füllmaterial zum Bilden einer vertiefungsfrei planen Oberfläche aufgefüllte Bemusterung, zum Herstellen einer Lötstopmaske,
wobei das Füllmaterial so ausgewählt ist, dass dieses sowohl auf dem Trägersubstrat, als auch auf dem Maskierungsmaterial haftet,
und das Auftragen der Bemusterung und Auffüllen von Zwischenräumen derselben zum Herstellen der eine Mehrzahl von aufeinanderliegenden Leiterbahnverläufen aufweisenden Mehrlagen- bzw. Multilayer-Leiterplatte sukzessiv erfolgt.

2. Verfahren nach Anspruch 1, **dadurch gekennzeichnet, dass** als metallhaltige Paste eine Kupferleitpaste und/oder ein thermisch härtendes Gemisch aus einem Metall sowie einem Harz und/oder Kunststoff gewählt wird.

3. Verfahren nach Anspruch 1 oder 2, **dadurch gekennzeichnet, dass** die metallhaltige Paste so hergestellt ist, dass eine Leitfähigkeit der Bemusterung im Bereich zwischen 1 und 10 mOhm x cm, insbesondere zwischen 3 und 7 mOhm x cm, liegt.

4. Verfahren nach einem der Ansprüche 1 bis 3, **dadurch gekennzeichnet, dass** als Füllmaterial ein Lötstop-und/oder Isolierlack verwendet wird.

5. Verfahren nach Anspruch 4, **dadurch gekennzeichnet, dass** das Füllmaterial thermisch härtend ausgebildet ist.

6. Verfahren nach einem der Ansprüche 1 bis 5, **dadurch gekennzeichnet, dass** für das Füllmaterial (22) das selbe Material wie für das Maskierungsmaterial (24) verwendet wird.

7. Verfahren nach einem der Ansprüche 1 bis 6, **dadurch gekennzeichnet, dass** eine Schichtdicke der Bemusterung auf einen Bereich zwischen 18 und 70 Mikrometern und/oder eine Schichtdicke der Lötstopmaske auf einen Bereich zwischen 14 und 20 Mikrometern eingerichtet wird.

8. Verfahren nach einem der Ansprüche 1 bis 7, **dadurch gekennzeichnet, dass** als Trägersubstrat eine gekrümmte Oberfläche zum Aufbringen der Bemusterung aufweisende Materialplatte verwendet wird.

9. Verfahren nach einem der Ansprüche 1 bis 8, **gekennzeichnet durch** das Versilbern oder Vergolden von in der Lötstopmaske freiliegenden Kontaktabschnitten der Bemusterung.

10. Verfahren nach einem der Ansprüche 1 bis 9, **gekennzeichnet durch** das SMD-Bestücken mit ElektronikBauelementen.

## Claims

1. Method of producing a multilayer circuit board on which electronic components can be mounted, comprising the steps of:
- applying an electrically conductive pattern, which corresponds to a printed conductor path (12, 16, 20), has a layer thickness of < 100 micrometres and is made of a metal-containing, solderable paste, onto a non-conductive carrier substrate (10) by means of a screen-printing process,
- filling the non-conductive gaps in the pattern which are defined by the printed conductor path by applying a filler material (14, 18, 22) having said layer thickness by means of a screen-printing process,
- selective application of mask material (24), which has insulating properties and/or stops the flow of solder by means of a screen-printing process onto the pattern, which is filled with the filling material to form a planar, recess-free surface, in order to produce a solder resist mask,
wherein the filler material is selected in such a way that it bonds adhesively to both the carrier substrate and the mask material,
and the steps of applying the pattern and filling the gaps therein are carried out successively to produce the multilayer circuit board having a plurality of printed conductor paths on top of one another.

2. Method according to claim 1, **characterised in that** a copper conductive paste and/or a thermally-hardening mixture of a metal and a resin and/or plastics material is selected as the metal-containing paste.

3. Method according to either claim 1 or claim 2, **characterised in that** the metal-containing paste is produced in such a way that the conductivity of the pattern lies in the range between 1 and 10 mΩ x cm, in particular between 3 and 7 mΩ x cm.

4. Method according to any one of claims 1 to 3, **characterised in that** a solder resist and/or insulating coating is used as the filler material.

5. Method according to claim 4, **characterised in that** the filler material is formed so as to harden thermally.

6. Method according to any one of claims 1 to 5, **characterised in that** the same material - is used for the filler material (22) as is used for the mask material (24).

7. Method according to any one of claims 1 to 6, **characterised in that** a layer thickness of the pattern is provided in a range between 18 and 70 micrometres and/or a layer thickness of the solder resist mask is provided in a range between 14 and 20 micrometres.

8. Method according to any one of claims 1 to 7, **characterised in that** a curved surface is used as a carrier substrate for application of the material plate comprising the pattern.

9. Method according to any one of claims 1 to 8, **characterised by** silver-plating or gold-plating the free contact portions of the pattern in the solder resist mask.

10. Method according to any one of claims 1 to 9, **characterised by** SMD mounting with electronic components.

## Revendications

1. Procédé de fabrication d'une carte à circuit imprimé multi-couches sur laquelle peuvent être montés des composants électroniques, comprenant les étapes :
- application d'un motif conducteur électrique correspondant à un tracé de pistes de conduction (12, 16, 20) d'une épaisseur < 100 micromètres d'une pâte pouvant être soudée, contenant du métal, sur un substrat de support (10) non conducteur au moyen d'un procédé de sérigraphie,
- remplissage des interstices non conducteurs définis par le tracé de pistes de conduction dans le motif par application d'un matériau de remplissage (14, 18, 22) de l'épaisseur d'une couche, au moyen d'un procédé de sérigraphie,
- application sélective d'un matériau de masquage (24) isolant et/ou stoppant le flux de soudure, au moyen d'un procédé de sérigraphie, sur le motif rempli par le matériau de remplissage pour l'obtention d'une surface plane sans rainures, pour l'obtention d'un masque d'arrêt de soudure,
dans lequel le matériau de remplissage est ainsi sélectionné qu'il adhère aussi bien au substrat de support qu'au matériau de masquage,
et dans lequel l'application du motif et le remplissage des interstices de celui-ci se fait successivement afin de fabriquer la carte à circuit imprimé multi-couches comportant une pluralité de tracés de pistes de conduction empilés.

2. Procédé selon la revendication 1, **caractérisé en ce qu'**une pâte conductrice de cuivre et/ou un mélange durcissant thermiquement d'un métal et d'une résine ou d'un matériau plastique est sélectionné en tant que pâte contenant du métal.

3. Procédé selon la revendication 1 ou 2, **caractérisé en ce que** la pâte contenant du métal est ainsi fabriquée que la conductivité du motif est dans le domaine entre 1 et 10 mOhm x cm, en particulier dans le domaine entre 3 et 7 mOhm x cm.

4. Procédé selon l'une des revendications 1 à 3, **caractérisé en ce qu'**une laque isolante et/ou d'arrêt de soudure est utilisée comme matériau de remplissage.

5. Procédé selon la revendication 4, **caractérisé en ce que** le matériau de remplissage est formé de manière à être durcissant thermiquement.

6. Procédé selon l'une des revendications 1 à 5, **caractérisé en ce que** le matériau de remplissage (22) est le même matériau que celui utilisé pour le pour le matériau de masquage (24).

7. Procédé selon l'une des revendications 1 à 6, **caractérisé en ce qu'**une épaisseur de couche du motif est agencée dans le domaine entre 18 et 70 micromètres, et/ou qu'une épaisseur du masque d'arrêt de soudure est agencée dans le domaine entre 14 et 20 micromètres.

8. Procédé selon l'une des revendications 1 à 7, **caractérisé en ce qu'**une plaque de matériau présentant une surface courbe pour l'application du motif, est utilisé comme substrat de support.

9. Procédé selon l'une des revendications 1 à 8, **caractérisé en ce qu'**une dorure ou une argenture des portions de contact dénudées dans le masque d'arrêt de soudure du motif est pratiquée.

10. Procédé selon l'une des revendications 1 à 9, **caractérisé en ce qu'**un montage CMS avec des composants électroniques est pratiqué.
